(19) Europäisches Patentamt
European Patent Office
Office européen des brevets

(11) **EP 3 427 285 B1**

(12) **FASCICULE DE BREVET EUROPEEN**

(45) Date de publication et mention de la délivrance du brevet:
**22.01.2020 Bulletin 2020/04**

(21) Numéro de dépôt: **17713353.5**

(22) Date de dépôt: **08.03.2017**

(51) Int Cl.:
*H01J 27/02* *(2006.01)*    *H01J 37/05* *(2006.01)*
*G21K 1/02* *(2006.01)*    *H05H 7/04* *(2006.01)*
*H05H 7/08* *(2006.01)*

(86) Numéro de dépôt international:
**PCT/FR2017/050510**

(87) Numéro de publication internationale:
**WO 2017/153680 (14.09.2017 Gazette 2017/37)**

(54) **DISPOSITIF DE MODULATION DE L'INTENSITÉ D'UN FAISCEAU DE PARTICULES CHARGÉES, PROCÉDÉ DE DÉVIATION DE SON AXE D'ÉMISSION D'UN FAISCEAU DE PARTICULES CHARGÉES UTILISANT CE DISPOSITIF ET ENSEMBLE D'ÉMISSION D'UN FAISCEAU DE PARTICULES CHARGÉES D'INTENSITÉ MODULABLE, COMPRENANT CE DISPOSITIF**

VORRICHTUNG ZUM MODULIEREN DER INTENSITÄT EINES GELADENEN TEILCHENSTRAHLS, VERFAHREN ZUM ABWEICHEN EINES GELADENEN TEILCHENSTRAHLS VON DER EMISSIONSACHSE MIT DIESER VORRICHTUNG UND SYSTEM MIT DIESER VORRICHTUNG.

DEVICE FOR MODULATING THE INTENSITY OF A CHARGED PARTICLE BEAM, METHOD FOR DEVIATING A CHARGED PARTICLE BEAM FROM THE AXIS OF EMISSION WITH SAID DEVICE AND SYSTEM INCLUDING THIS DEVICE.

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.03.2016 FR 1651912**

(43) Date de publication de la demande:
**16.01.2019 Bulletin 2019/03**

(73) Titulaires:
• **Pantechnik**
  **14400 Bayeux (FR)**
• **A.D.A.M. SA**
  **1217 Meyrin (CH)**

(72) Inventeurs:
• **SALOU, Pierre**
  **14400 Monceaux en Bessin (FR)**
• **FINK, Daniel**
  **1203 Geneva (CH)**

(74) Mandataire: **IP Trust**
**2, rue de Clichy**
**75009 Paris (FR)**

(56) Documents cités:
WO-A2-2007/133225    JP-A- H10 302 711
JP-A- 2003 132 828    US-A- 4 953 192
US-A1- 2008 211 376    US-A1- 2009 050 819
US-A1- 2014 001 372

**Description**

**Domaine technique de l'invention**

L'invention concerne le domaine technique des instruments produisant des faisceaux de particules chargées dans une gamme d'énergie allant de 1 eV/charge à plusieurs $10^{12}$ eV/q.

Des instruments de ce type trouvent des applications dans de nombreux domaines selon la charge, la masse, l'énergie cinétique de particules accélérées :

- équipement des accélérateurs de particules
- implantation ionique (traitement de surface etc...)
- médical (hadronthérapie, production radioisotope, nanomédicaments...)
- dépôt sous vide
- micro-gravure
- propulsion ionique pour engins spatiaux
- spectromètre de masse par accélération pour l'analyse d'échantillon,
- datation

L'invention vise plus particulièrement la modulation de l'intensité (ou courant ou le flux de particules) du faisceau de particules chargées produit afin d'en moduler l'impact sur l'échantillon visé et de pouvoir varier les utilisations possibles d'un même instrument.

**Etat de la technique et ses inconvénients**

Les faisceaux de particules chargées peuvent actuellement être modulés en courant de différentes manières, notamment :

- en variant l'intensité de la source de particules chargées
- en collimatant le faisceau à l'aide de pièces mécaniques amovibles (ex : système de fentes, iris)
- en pulsant le faisceau avec différents rapport cycliques.

Les différentes techniques présentées précédemment posent cependant de nombreux problèmes techniques : L'utilisation de faisceaux pulsés n'est par exemple pas applicable dans toutes les applications des faisceaux de particules chargées.

Le réglage de l'intensité de la source de particules chargées ainsi que l'utilisation de collimateurs amovibles mécaniquement ne répondent pas aux contraintes de réactivité nécessaires à certaines applications.

Dans l'exemple du document US 8 896 238, l'on parvient à moduler le courant d'un faisceau d'une source d'ions générant un faisceau d'ions courbe au sein d'un accélérateur particulier de type cyclotron. La modulation en intensité de ce faisceau s'effectue à l'aide d'une électrode Dee connectée à un générateur de hautes fréquences qui applique à l'électrode Dee une haute tension alternative d'une amplitude qui peut être modulée par un régulateur. Les ions sont accélérés entre l'électrode Dee et une contre-électrode reliée à la masse, à travers un gap et définissent, du fait de l'application de tensions de différentes amplitudes sur l'électrode Dee, des trajectoires circulaires de différents rayons. Un écran plein disposé à distance de la contre-électrode délimite avec cette dernière un espace de passage pour les ions présentant une trajectoire d'une courbure dépassant une valeur critique, et définit un obstacle pour les ions dont la courbure est en deçà de cette valeur critique. La modulation de l'amplitude de la tension appliquée à l'électrode Dee qui modifie les trajectoires différentes des ions, combinée à la présence de l'écran, permet de moduler le nombre d'ions et ainsi le courant finalement émis par la source.

Cependant, ce dispositif est propre aux particules chargées à trajectoires courbes émises par une source de cyclotron et n'est pas transposable à un dispositif émettant un faisceau de particules chargées linéaire.

Le document US 3 286 123 concerne bien un appareil d'émission d'un faisceau de particules linéaire. Dans cet appareil, sous l'effet d'une électrode perforée, d'un système de déflection et de multiples lentilles réparties le long de l'axe de leur émission, et de la présence d'un déflecteur, le faisceau de particules chargées est dévié de sa trajectoire initiale selon des profils variables dépendants de la position et de la focale des lentilles et certaines pourront être collectées par un collecteur placé perpendiculairement à l'axe de l'émission des particules. Les applications de cet appareil ne sont cependant pas compatibles à celles visées par l'invention le faisceau de particules chargées étant définitivement dévié de son axe initial et non récupérable à un emplacement fixe donné.

D'autres appareils générant des faisceaux de particules chargées linéaires et pourvus de moyens de modulation sont connus mais cette modulation est effectuée sur l'énergie de ce faisceau et non sur le courant (la quantité) de particules :

- le document EP 2592642 concerne un dispositif d'émission d'un faisceau de particules chargées comprenant une succession d'éléments octopolaires (302, 304, 306, 308) susceptibles d'être le siège d'excitations dipolaires, quadripolaires et hexapolaires, les deux premiers éléments permettant une dispersion en hauteur et en énergie du faisceau, les deux éléments centraux étant séparés par un collimateur pourvu d'un orifice en forme de fente laissant passer une portion des particules d'une énergie donnée et interceptant les autres. Ce dispositif permet ainsi de moduler l'énergie du faisceau de particules chargées mais pas l'intensité du faisceau sortant qui reste sensiblement la même,

- par ailleurs, le document US 8039822 concerne un appareil de thérapie par particules comportant un accélérateur pour générer un faisceau de particules chargées, un modulateur d'énergie passive comprenant un élément absorbant et une entité de commande. L'entité de commande est conçue pour commuter entre un ajustement actif de l'énergie contenue dans l'accélérateur et une modulation de l'énergie passive par le modulateur d'énergie, dans le but de modifier l'énergie du faisceau de particules chargées à partir d'un niveau d'énergie élevé à un faible niveau d'énergie dans une étape par étape manière. En particulier, cela a pour effet de raccourcir les temps morts lors d'un changement entre les niveaux d'énergie mais toujours pas la possibilité de moduler l'intensité du faisceau sortant.

Le document US 9 224 569 décrit une source d'ions à haute luminosité avec une chambre à gaz qui comprend différents compartiments ayant chacun un gaz différent. Un faisceau d'électrons est amené, au moyen de plaques de déflexion, à passer sélectivement à travers l'un des compartiments pour fournir des ions d'une certaine espèce pour le traitement d'un échantillon. Il est possible de modifier facilement l'espèce d'ions fournie en dirigeant les électrons à travers d'autres compartiments contenant une espèce de gaz différente afin de traiter un échantillon avec des ions d'une autre espèce. Si la nature des ions générés est facilement et rapidement modifiée, le nombre d'espèce d'ions est réduit à celui du nombre de compartiments de la chambre de gaz, et les éventuelles différentes intensités des faisceaux de différents ions possibles, sont également réduites au nombre de compartiments de la chambre. Ce système ne permet pas une modification continue de l'intensité du faisceau fourni.

Le document US 2009/0050819 A1 divulgue un dispositif compact de sélection et de collimation de particules pour délivrer des faisceaux de protons avec des spectres d'énergie désirés.

Aucune solution satisfaisante n'a donc encore été trouvée pour moduler en intensité et de façon continue le faisceau de particules chargées émis par une source alimentant un accélérateur linéaire.

**Exposé de l'invention**

L'invention vise à résoudre ce problème en proposant un dispositif de modulation de l'intensité d'un faisceau de particules chargées selon la revendication 1.

Le dispositif selon l'invention peut par ailleurs présenter l'une et/ou l'autre des caractéristiques suivantes :

- chacun desdits systèmes de déviation est de type électrique ou de type magnétique
- lorsque les systèmes de déviation sont de type électrique, chaque système est constitué de deux plaques parallèles portées à un potentiel électrique et disposées respectivement de part et d'autre de l'axe d'émission A0.
- lorsque les systèmes de déviation sont de type magnétique chacun desdits systèmes de déviation est constitué par un dipôle magnétique.
- la fente d'un collimateur présente une forme générale de V avec des bords opposés rectilignes ou courbes bombés vers la partie restante du collimateur ou vers l'espace vide délimité par ces bords.
- chaque collimateur est placé le long de l'axe de façon à ce que sa fente soit disposée d'un côté de l'axe d'émission A0 en étant décalée vis-à-vis de cet axe A0 d'une distance d.
- ou chaque collimateur est placé le long de l'axe de façon à ce que sa fente soit disposée dans l'axe d'émission A0
- lorsque le dispositif comprend 8 systèmes de déviation, quatre de ces systèmes sont disposés vis-à-vis de l'axe d'émission de façon à dévier le faisceau émis selon une première direction, et quatre autres de ces systèmes sont disposés vis-à-vis de l'axe d'émission de façon à dévier le faisceau émis selon une deuxième direction perpendiculaire à la première.

L'invention concerne un procédé de déviation de son axe d'émission d'un faisceau de particules chargées émises suivant un axe A0, à l'aide du dispositif ci-dessus, comprenant pour 4N systèmes de déviation successifs, une étape d'application :

- par le premier système de déviation d'une première force de déviation du faisceau suivant une direction donnée et selon un premier sens,

- par le deuxième système de déviation d'une deuxième force de déviation supérieure à la première, selon la même direction et en sens inverse du premier,
- par le troisième système de déviation du faisceau, de la deuxième force de déviation du faisceau suivant la même direction et selon le premier sens de déviation,
- par le quatrième système de déviation, de la première force de déviation, selon la même direction et en sens inverse du premier.

Idéalement, les systèmes de déviation sont de type électrique, et comprennent chacun deux plaques parallèles à l'axe A0 et disposées de part et d'autre de cet axe A0, les potentiels appliqués sur les deux plaques d'un même système étant symétriques ou asymétriques.

Selon une autre réalisation possible, chaque système de déviation est composé de deux plaques disposées de part et d'autre de l'axe (A0), deux ou plus de plaques de différents systèmes de déviation étant mises à la terre, les forces de déviation du faisceau des systèmes de déviation des plaques étant différentes, des facteurs de correction (Uib) étant appliqués à chaque force de déviation imposée à un système de déviation dont l'une des plaques est à la masse afin de corriger l'angle de sortie du faisceau.

Selon une autre caractéristique, on applique des forces de déviation ajustables supplémentaires à un ou plusieurs système de déviation afin de corriger l'angle de sortie du faisceau.

L'invention concerne également un ensemble d'émission d'un faisceau de particules chargées d'intensité modulable, comprenant successivement le long d'un axe d'émission A0 du faisceau :

- une source d'émission d'un faisceau de particules chargées centré autour d'un axe d'émission A0, de préférence de type ECR
- un système d'extraction
- une lentille de type Einzel
- un collimateur à orifice central circulaire
- le dispositif de modulation de l'intensité du faisceau en sortie du premier collimateur,
- un deuxième collimateur à orifice central circulaire
- un filtre des particules en sortie du deuxième collimateur, par la vitesse

**Présentation des figures**

D'autres données, caractéristiques et avantages de la présente invention apparaîtront à la lecture de la description non limitée qui suit, en référence aux figures annexées qui représentent, respectivement :

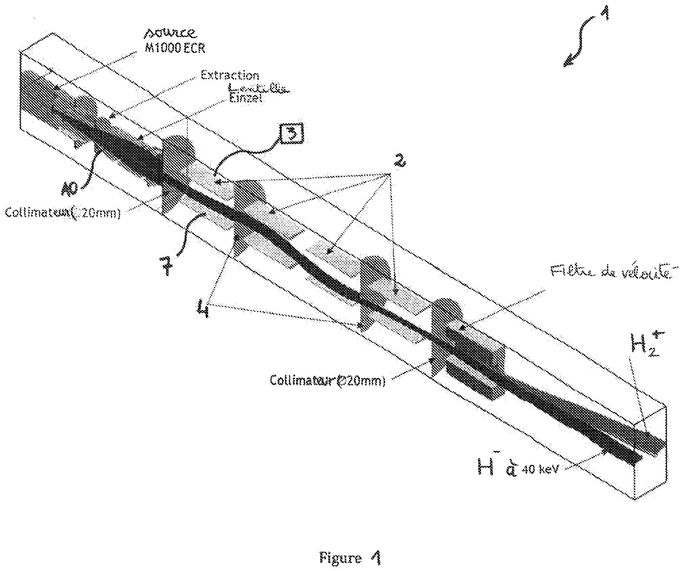

- la figure 1 représente par une vue en perspective un ensemble d'émission d'un faisceau de particules chargées d'intensité modulable pourvu d'un dispositif de modulation d'intensité selon l'invention
- la figure 2 représente une vue schématique en section longitudinale du dispositif de modulation de la figure 1, mettant en évidence les collimateurs à fentes en V de ce dispositif,
- la figure 3 représente quatre vues analogues à celles de la figure 2 pour différentes tensions appliquées
- la figure 4 illustre par un graphique l'évolution de l'intensité du faisceau I de particules en sortie du dispositif de modulation rapportée à l'intensité de faisceau à l'entrée I0, en fonction de la tension U2 appliquée sur les systèmes de déviation
- la figure 5 représente le dispositif de la figure 2 faisant apparaître les lignes de potentiels appliquées avec des potentiels symétriques (5(a) et des potentiels asymétriques (5(b)
- la figure 6 illustre l'émittance de faisceaux dans le cas de potentiels symétriques (figure 6(a)) et asymétriques (figure 6(b)), l'ellipse représentée correspondant à l'acceptance d'une ligne de faisceau particulière, et mettant en évidence le fait qu'il est possible, en recourant à une asymétrie de potentiels (tous en gardant une symétrie de forces) de corriger les aberrations optiques du dispositif pour rendre le faisceau compatible avec le reste d'une ligne.

**Description détaillée d'un exemple de réalisation**

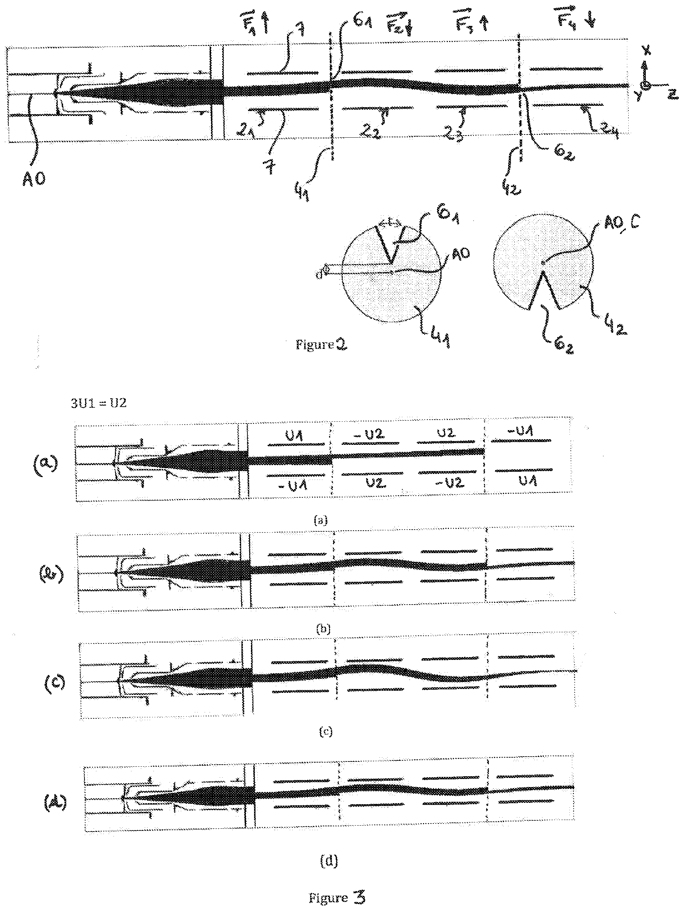

Conformément à la figure 2, l'invention concerne un dispositif de modulation de l'intensité d'un faisceau de particules chargées 1.

Ce dispositif est disposé en aval d'une source de particules de type ECR, d'un système d'extraction, d'une lentille de type Einzel et d'un collimateur avec un orifice central circulaire de diamètre 20 mm dans l'exemple illustré, et en amont d'un deuxième collimateur à orifice central circulaire, et éventuellement d'un filtre de vitesse des particules afin que celles-ci soient utilisées pour diverses applications.

L'ensemble à source de particules, système d'extraction, lentille et premier collimateur émet en sortie un faisceau de particules chargées d'intensité I0 suivant un axe A0.

Le dispositif de modulation de l'intensité du faisceau de particules chargées selon l'invention comprend :

- 4xN systèmes de déviation 2, avec N = 1 (ou 2 selon une variante non illustrée), les systèmes de déviation 2 étant placés le long de l'axe de l'émission A0 dudit faisceau de particules,
- des moyens 3 d'application d'une force de déviation du faisceau pour chaque système de déviation 2 (un seul de ces moyens étant schématiquement représenté),
- deux collimateurs à fente en V $4_1$, $4_2$ placés respectivement entre le premier et le deuxième système de déviation et entre le troisième et quatrième système de déviation, pourvus chacun d'une fente $6_1$, $6_2$ de passage du faisceau dévié de son axe d'émission, chaque fente $6_1$, $6_2$ de collimateur présentant une largeur croissante du centre du collimateur vers la périphérie, la fente $6_1$ du premier collimateur $4_1$ étant disposée d'un côté de l'axe d'émission du faisceau A0, la fente $6_2$ du deuxième collimateur $4_1$ étant disposée de l'autre côté de l'axe du faisceau A0, les ouvertures des fentes étant orientées en sens inverse l'une de l'autre.

Dans l'exemple illustré sur les figures, les systèmes de déviation du dispositif selon l'invention, sont de type électrostatique et constitués chacun de deux plaques parallèles 7 disposées de part et d'autre de l'axe d'émission du faisceau A0. Les plaques des différents systèmes sont parallèles et équidistantes vis-à-vis de l'axe A0. On applique entre les deux plaques 7 d'un même système une différence de potentiel Ui (voir notamment figure 3) qui constitue pour le faisceau une force de déviation F, le déviant de sa trajectoire initiale A0 d'un côté de cet axe A0 selon la direction X repérée sur la figure 3.

L'on pourrait également utiliser des systèmes de déviation de type magnétique, ce qui rend la modulation applicable pour des faisceaux de hautes énergies et la force de déviation appliquée serait de type magnétique, cette variante de réalisation pouvant être illustrée schématiquement avec les mêmes figures que celles utilisées pour les systèmes de déviation de type électrique.

Dans ce premier exemple, les forces de déviation appliquées par les premier et quatrième systèmes sont égales en valeur absolue (2 U1) et les forces appliquées par les deuxième et troisième système sont égales en valeur absolue (2U2) afin de ramener le faisceau sur l'axe A0 en sortie de dispositif.

En outre, les tensions U1 et U2 sont selon ce premier exemple, dans la relation suivante : 3U1 = U2.

1) Lorsque le faisceau de particules chargées traverse le premier système de déviation 21, il est dévié d'un côté de l'axe (côté positif de l'axe X de la figure 2) par la force de déviation F exercée par ce premier système (U1/-U1). Cette déviation amène le faisceau à hauteur de la fente $6_1$ du premier collimateur $4_1$ qu'il rencontre sur son passage. Ce premier collimateur $4_1$ présente conformément à la figure 2, la forme d'une plaque circulaire dans l'exemple illustré mais pouvant bien entendu présenter d'autres formes, définissant un centre C coïncidant avec l'axe d'émission du faisceau A0 lorsque le collimateur est monté perpendiculairement à l'axe d'émission du faisceau A0, et pourvue d'une fente en forme général de V, dont la pointe est décalée d'une distance d au dessus du centre C et ainsi de l'axe d'émission A0 suivant la direction de la force de déviation.

En fonction de la force de déviation F1 appliquée par le premier système $2_1$ sur le faisceau, celui-ci sera plus ou moins dévié d'un côté (au-dessus) de l'axe d'émission A0 et une plus ou moins grande section de ce faisceau traversera la fente, le reste étant intercepté par la plaque du premier collimateur $4_1$.

2) La portion de faisceau dévié et sortant du premier collimateur $4_1$ débouche alors au niveau du deuxième système de déviation $2_2$ qui est le siège d'une force de déviation F2 (-U2/U2) en sens inverse de celle du premier système, et d'amplitude plus importante que celle-ci afin de dévier cette portion de faisceau de l'autre côté de l'axe démission A0 (en dessous).

3) La portion de faisceau du côté négatif de l'axe X débouche au niveau du troisième système de déviation $2_3$ qui est le siège d'une force de déviation F3 en sens inverse de celle du deuxième système (U2/-U2), et d'amplitude égale ou équivalente afin de dévier la portion de faisceau vers l'autre côté de l'axe X (vers le côté positif tout en restant du côté négatif) à proximité de l'axe A0.

Cette portion de faisceau rencontre en sortie du troisième système de déviation $2_3$, le deuxième collimateur $4_2$ pourvu d'une fente en V $6_2$ dont l'ouverture est orientée à l'opposé de celle du premier collimateur (c'est-à-dire dans l'exemple illustré, vers le côté négatif de l'axe X) pour plus ou moins laisser passer de particules en fonction des forces de déviation des systèmes précédents.

4) Le dernier système de déviation $2_4$ est le siège d'une force de déviation F4 ((-U1/U1) qui vient ramener le faisceau « rogné » par les deux fentes $6_1$, $6_2$ précisément dans l'axe d'émission initial A0. Son sens est inverse de la force exercée par le système de déviation précédent et son amplitude moindre.

Conformément à la figure 3, la variation des potentiels appliqués (ou force de déviation du faisceau appliquée) par chacun des systèmes de déviation, permet de varier l'intensité du faisceau en sortie de dispositif :

- dans l'exemple de la figure 3(a), la totalité des particules est stoppée du fait du lieu d'arrivée du faisceau sur chaque collimateur (la portion de faisceau ayant traversé la première fente 61 ne traverse pas la deuxième fente 62 mais est interceptée par le collimateur 42 car elle atteint le collimateur au-dessus de la deuxième fente)
- dans l'exemple de la figure 3(c), la quasi-totalité des particules traverse le dispositif (la quasi-totalité des particules traverse la première fente, et la quasi-totalité de la portion de faisceau sortant du premier collimateur traverse la deuxième fente)
- les exemples des figures 3(b) et 3(d) illustrent des situations intermédiaires entre les situations 3(a) et 3(c).

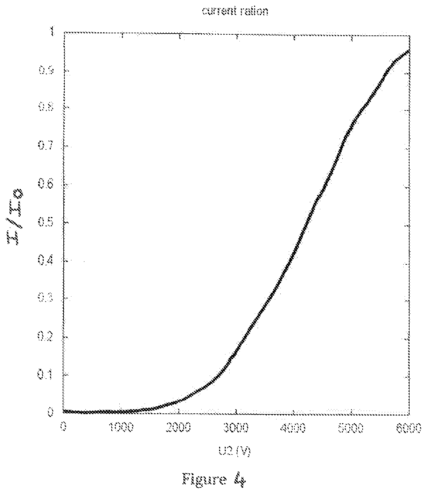

Conformément à la figure 4, il est possible d'obtenir en sortie de dispositif, une variation de l'intensité du faisceau de particules chargées comprise entre 0 et 96% du faisceau émis par la source en faisant varier l'intensité U2, avec dans l'exemple illustré, la proportion 3U1 = U2.

## Modification de la tension

Selon un deuxième exemple de réalisation possible, les forces de déviation appliquées par les quatre systèmes de déviation successifs sont distinctes deux à deux: 2U1 pour le premier système, 2U2 pour le deuxième système, 2U3 pour le troisième système et 2U4 pour le quatrième système, avec pour chaque système, deux plaques inférieure et supérieure à des potentiels égaux en valeur absolue et de sens inverse.

Par exemple, les tensions U1, U2, U3, U4 peuvent être dans les relations suivantes :

$$U1 = \frac{U * U1a}{k} + U1b + D * U$$

$$U2 = -U * U2a + U2b + B * U$$

$$U3 = U * U3a + U3b + B * U$$

$$U4 = \frac{-U*U4a}{k} + U4b + D * U$$

*avec :*

U paramètre tension de la chicane en Volt,
k coefficient sans dimension, qui représente le ratio positif entre la tension appliquée entre les deux plaques extérieures $2_1$, $2_4$ et celle appliquée entre deux plaques intérieures $2_2$, $2_3$,
U1a, U2a, U3a, U4a, U1b, U2b, U3b, U4b, B, D des facteurs de correction en volt.

Avec un coefficient k = 3 le faisceau doit quitter la chicane sans décalage ni déviation. A cet effet, on fixe U1a, U2a, U2a, U2a chacun égal à 1 et U1b, U2b, U3b, U4b, B, D fixés à 0.

La modulation de l'intensité est obtenue par interception partielle du faisceau par les collimateurs à fentes en V tel que décrit précédemment. L'amplitude de l'interception dépend de la déviation, elle même fonction de la tension de la chicane $2_i$ considérée. Les facteurs de corrections U1a, U2a, U3a, U4a, U1b, U2b, U3b, U4b, B, D sont identiques pour un même paramètre tension U. **Par exemple, ces facteurs de correction peuvent être fixés à** : k entre 2,5 et 3,5; U1a,U2a,U3a et U4a entre 0 et 2 ; U1b,U2b,U3b et U4b entre -1000V et +1000V et B,D entre 0 et 2.

## Modification de la forme des fentes

Il est possible de modifier la forme des fentes de façon à modifier également le comportement de la modulation (par exemple en rendant la modulation plus précise pour les faibles courants). Ainsi, les côtés opposés des fentes pourraient être rectilignes ou non, courbes bombés vers la partie pleine du collimateur ou au contraire bombés vers l'espace vide de la fente. On prévoit que la fente de chaque collimateur soit décalée vis-à-vis du centre C pour couper le faisceau en sortie lorsque les systèmes de déviation ne sont pas alimentés.

Par exemple, l'on pourra prévoir pour la fente :
→ pour une plus grande sensibilité pour les faibles intensités

◦ plage de 2μA à 200 μA, avec une précision de 2% :
◦ intérêt à avoir une dérivation de la courbe basse pour les faibles intensités d'où profil évasé de la fente, avec pente quasi radiale au centre et ouverture croissante vers la périphérie.
◦ Ou fermeture de la fente vers la périphérie pour limiter l'intensité
◦ Ou décalage en dessous du centre, pour garantir une intensité minimale même en l'absence de potentiel appliqué aux plaques.

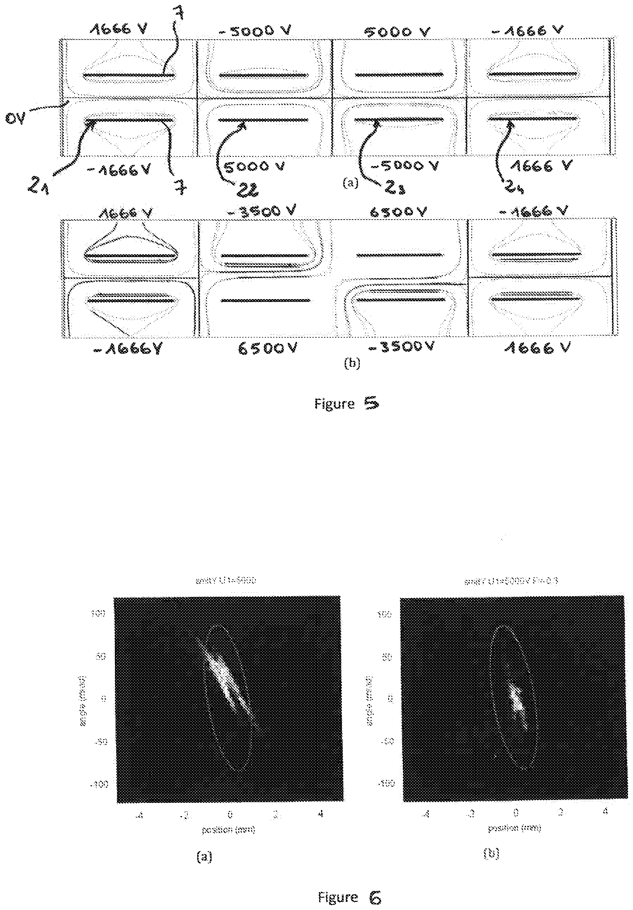

Le dispositif de modulation peut être couplé à un système de mesure de courant (de type cage de Faraday ou mesure non intersective) positionné en aval du dernier système de déviation, afin d'effectuer un réglage précis du courant par une boucle de régulation en agissant sur la force de déviation exercée par les systèmes de déviation.
Les potentiels appliqués sur les plaques de déviation d'un même système de déviation peuvent être symétriques afin de limiter le nombre d'alimentations électriques conformément à la figure 5(a) (intensité du faisceau recueillie visible sur la figure 6a).
Autrement, il est possible d'utiliser pour deux plaques d'un même système, des potentiels non symétriques (figure 5(b) : potentiels des systèmes 22 et 23 dont les deux plaques sont élevées en valeur absolue à 3500 V et 6500 V respectivement), ceci permettant de meilleures propriétés de faisceau en sortie qui s'inscrit alors entièrement à l'intérieur d'une zone donnée (limitation de l'émittance et des aberrations, voir figure 6b).

Cas d'une déviation du faisceau incident vis à vis de l'axe A0

Un mode de réalisation alternatif est requis s'il existe un angle d'incidence sur le faisceau, un désalignement de la structure mécanique, ou une asymétrie du champ, impliquant que le faisceau quitte la structure d'une chicane avec un angle $\alpha(U)$ vis à vis de l'axe A0. L'angle de sortie $\alpha(U)$ du faisceau peut être une fonction du paramètre U de la chicane et donc non constant.
L'invention permet de corriger cet angle de déviation instantanément en cassant la symétrie de la tension appliquée à la chicane. Cela est rendu possible en mettant à la terre deux ou plus des plaques avec des tensions différentes U1, U2, U3, ou U4 et en faisant varier respectivement le facteur de correction correspondant U1b, U2b, U3b, et U4b.
Dans la configuration modifiée de la chicane, chaque tension U1, U2, U3, et U4 doit rester appliquée à au moins une plaque.
Les valeurs des facteurs de correction peuvent être expérimentalement déterminés pour chaque point défini du paramètre U de la chicane.
La modulation d'intensité par la chicane modifiée est donc décrite par I(U, Uib), où Uib sont les facteurs de correction avec i=1,2,3,4 des tensions correspondantes Ui pour lequel une des plaques a été mise à la terre.
En variante, il est possible de corriger l'angle de sortie en appliquant des tensions ajustables supplémentaires individuelles à une ou plusieurs plaques au lieu de les mettre à la terre.

*Formules pour ce mode de réalisation de la chicane*

La mise à la terre d'une des plaques nécessite un doublement de la tension de la plaque opposée pour diriger le faisceau à travers la chicane. Les formules classiques de chicane peuvent être modifiées de la façon suivante:

U1'=2*U1, Si la plaque supérieure $2_4$ ou la plaque inférieure $2_1$ est mise à la terre.
U2'=2*U2, Si la plaque supérieure $2_3$ ou la plaque inférieure $2_2$ est mise à la terre.
U3'=2*U3, Si la plaque supérieure $2_2$ ou la plaque inférieure $2_3$ est mise à la terre.
U4'=2*U4, Si la plaque supérieure $2_1$ ou la plaque inférieure $2_4$ est mise à la terre.

L'une des réalisations pratiques possibles de la chicane modifiée serait de mettre à la terre les plaques supérieures $2_1$ et $2_4$ et de doubler les tensions U1 et U4. La direction introduite par la chicane peut être corrigée en modifiant U1b en fonction du paramètre de chicane U: U1b (U). Dans ce cas, la modulation d'intensité par la chicane modifiée est définie par I (U, U1b(U)).
Par exemple, pour cette réalisation et avec notre structure spécifique nous avons trouvé les paramètres suivants (U1a=2, U2a=1, U3a=1, U4a=2, B=D=0, k =2.7 sont constants) pour quelques intensités mesurées dans l'intervalle entre 1 μA et 300 μA:

| Intensité mesurée, I(U,U1b(U)) | Tension de la chicane, U | Facteurs de correction, U1b |
|:---:|:---:|:---:|
| [gA] | [V] | [V] |
| 296 | 5000 | 150 |
| 220 | 4000 | 30 |
| 123 | 3000 | -125 |
| 46 | 2000 | -150 |
| 23 | 1500 | -170 |
| 3 | 1000 | -220 |

Avec ces valeurs, nous avons trouvé le centre du faisceau sur l'axe faisceau a la position du plan de mesure.

Pour couvrir tout l'intervalle sans interruption, il faut trouver la relation *Ulb(U)* entre le facteur de correction et la tension de la chicane. Dans le cas général il faut trouver toutes les relations *Uib(U)* avec i = 1,2,3,4.

Veuillez noter que les paramètres de la chicane et les facteurs de correction ne sont pas valides universellement et peuvent changer pour d'autres installations.

La mise à la terre des plaques inférieures conduit au même résultat.

Il est également possible d'appliquer les tensions dans l'ordre inverse et d'inverser l'orientation des collimateurs et le signe des tensions appliquées. Les formules pour la chicane modifiée restent les mêmes.

Cas de huit systèmes de déviation

Par ailleurs, le dispositif selon l'invention peut comporter un jeu supplémentaire de quatre systèmes de déviation tels que décrits ci-dessus, qui viendra moduler l'intensité des particules dans la direction Y représentée schématiquement sur la figure 2. Les plaques de ces systèmes de déviation seront alors perpendiculaires à celles du premier jeu de systèmes de déviation.

Dimensions possibles du dispositif :

80 cm de long ; plaque de 15 cm sur 10 cm ; distance 8 cm entre les plaques ; distance de 3-4 cm entre deux plaques consécutives ; côté de la fente 4 cm, angle d'ouverture 60°

Applications possibles :

Protonthérapie, adronthérapie : pour irradier de manière maîtrisée pour chaque voxel d'une tumeur par exemple.

Plus précisément, l'invention trouve une application dans la protonthérapie, en particulier celle utilisant des accélérateurs linéaires pour accélérer des faisceaux de protons, et utilisant en particulier un faisceau de proton pulsé où l'invention peut être utilisée pour moduler ou modifier l'intensité d'un faisceau de proton pour un traitement par radiothérapie.

Implantation ionique : modulation de la dose implantée localement, en fonction du balayage

Spectrométrie : éviter de saturer le détecteur

Microgravure : moduler l'efficacité locale de la gravure pendant le balayage

**Revendications**

1.   Dispositif de modulation de l'intensité d'un faisceau de particules chargées émis suivant un axe (A0), comprenant :

• 4xN systèmes de déviation successifs ($2_1$, $2_2$, $2_3$, $2_4$), avec N = 1 ou 2, les systèmes de déviation ($2_1$, $2_2$, $2_3$, $2_4$) étant placés le long de l'axe (A0) dudit faisceau de particules, et étant susceptibles de dévier le faisceau vis-à-vis de l'axe (A0) selon la même direction, avec pour deux systèmes successifs ($2_1$, $2_2$, $2_3$, $2_4$), des sens alternés de déviation,

• des moyens d'application d'une force de déviation du faisceau pour chaque système de déviation ($2_1$, $2_2$, $2_3$, $2_4$) et de variation de la force appliquée,

**caractérisé par**

• deux collimateurs ($4_1$, $4_2$) présentant chacun une fente ($6_1$, $6_2$) avec une ouverture de largeur croissante du centre vers la périphérie, placés respectivement entre le premier et le deuxième système de déviation et entre le troisième et quatrième système de déviation, l'ouverture de la fente ($6_1$) du premier collimateur ($4_1$) étant orientée vers un côté de l'axe d'émission du faisceau A0, l'ouverture de la fente ($6_2$) du deuxième collimateur ($4_1$) étant orientée vers le côté opposé de l'axe du faisceau (A0).

2. Dispositif selon la revendication 1 **caractérisé en ce que** chacun desdits systèmes de déviation ($2_1$, $2_2$, $2_3$, $2_4$) est de type électrique ou de type magnétique.

3. Dispositif selon la revendication 2, **caractérisé en ce que** lorsque les systèmes de déviation ($2_1$, $2_2$, $2_3$, $2_4$) sont de type électrique, chaque système ($2_1$, $2_2$, $2_3$, $2_4$) est constitué de deux plaques parallèles (7) portées à un potentiel électrique disposées respectivement de part et d'autre de l'axe d'émission (A0).

4. Dispositif selon la revendication 2 **caractérisé en ce que** lorsque les systèmes de déviation ($2_1$, $2_2$, $2_3$, $2_4$) sont de type magnétique, chacun desdits systèmes de déviation est constitué par un dipôle magnétique.

5. Dispositif selon l'une des revendications précédentes, **caractérisé en ce que** la fente ($6_1$, $6_2$) d'un collimateur ($4_1$, $4_2$) présente une forme générale de V avec des bords opposés rectilignes ou courbes bombés vers la partie restante du collimateur ($4_1$, $4_2$) ou vers l'espace vide délimité par ces bords.

6. Dispositif selon l'une des revendications précédentes, **caractérisé en ce que** chaque collimateur ($4_1$, $4_2$) est placé le long de l'axe de façon à ce que sa fente ($6_1$, $6_2$) soit disposée d'un côté de l'axe d'émission A0 en étant décalée vis-à-vis de cet axe A0 d'une distance d.

7. Dispositif selon l'une des revendications 1 à 5, **caractérisé en ce que** chaque collimateur ($4_1$, $4_2$) est placé le long de l'axe de façon à ce que sa fente ($6_1$, $6_2$) soit disposée dans l'axe d'émission A0.

8. Dispositif selon l'une des revendications précédentes, **caractérisé en ce que** lorsque qu'il comprend 8 systèmes de déviation ($2_1$, $2_2$, $2_3$, $2_4$), quatre de ces systèmes sont disposés vis-à-vis de l'axe d'émission de façon à dévier l'axe selon une première direction, et quatre autres de ces systèmes ($2_1$, $2_2$, $2_3$, $2_4$) sont disposés vis-à-vis de l'axe d'émission de façon à dévier l'axe selon une deuxième direction perpendiculaire à la première.

9. Procédé de déviation de son axe d'émission d'un faisceau de particules chargées émises suivant un axe A0, à l'aide du dispositif selon l'une quelconque des revendications précédentes, **caractérisé en ce qu'**il comprend pour 4N systèmes de déviation successifs, une étape d'application :

- par le premier système de déviation ($2_1$) d'une première force de déviation du faisceau suivant une direction donnée et selon un premier sens,
- par le deuxième système de déviation ($2_2$) d'une deuxième force de déviation supérieure à la première, selon la même direction et en sens inverse du premier,
- par le troisième système de déviation du faisceau ($2_3$), de la deuxième force de déviation du faisceau suivant la même direction et selon le premier sens de déviation,
- par le quatrième système de déviation ($2_4$), de la première force de déviation, selon la même direction et en sens inverse du premier.

10. Procédé selon la revendication 9, **caractérisé en ce que** les systèmes de déviation ($2_1$, $2_2$, $2_3$, $2_4$) sont de type électrique, et comprennent chacun deux plaques parallèles (7) à l'axe A0 et disposées de part et d'autre de cet axe A0, les potentiels appliqués sur les deux plaques d'un même système étant symétriques ou asymétriques.

11. Procédé selon la revendication 10, dans lequel chaque système de déviation est composé de deux plaques disposées de part et d'autre de l'axe (A0), deux ou plus de plaques de différents systèmes de déviation étant mises à la terre, les forces de déviation du faisceau des systèmes de déviation des plaques étant différentes, des facteurs de correction (Uib) étant appliqués à chaque force de déviation imposée à un système de déviation dont l'une des plaques est à la masse afin de corriger l'angle de sortie du faisceau.

12. Procédé selon la revendication 10, dans lequel on applique des forces de déviation ajustables supplémentaires à un ou plusieurs système de déviation afin de corriger l'angle de sortie du faisceau.

13. Ensemble d'émission d'un faisceau de particules chargées d'intensité modulable, comprenant successivement le long d'un axe d'émission A0 du faisceau :

- une source d'émission d'un faisceau de particules chargées centré autour d'un axe d'émission A0, de préférence de type ECR
- un système d'extraction
- une lentille de type Einzel
- un collimateur à orifice central circulaire
- le dispositif selon l'une quelconque des revendications 1 à 8,
- un deuxième collimateur à orifice central circulaire
- un filtre des particules en sortie du deuxième collimateur, par la vitesse.

**Patentansprüche**

1. Vorrichtung zur Modulation der Intensität eines Strahls geladener Teilchen, der entlang einer Achse (A0) emittiert wird, die folgendes umfasst:

   • 4xN aufeinanderfolgende Ablenksysteme ($2_i$, $2_2$, $2_3$, $2_4$) wobei N = 1 oder 2 ist, wobei die Ablenksysteme ($2i$, $2_2$, $2_3$, $2_4$) entlang der Achse (A0) des Partikelstrahls angeordnet sind und in der Lage sind, den Strahl von der Achse (A0) in die gleiche Richtung abzulenken, wobei bei zwei aufeinanderfolgenden Systemen ($2i$, $2_2$, $2_3$, $2_4$) die Ablenkrichtungen wechseln,
   • für jedes Ablenksystem ($2i$, $2_2$, $2_3$, $2_4$) Mittel zur Anwendung einer Strahlablenkkraft und zum Verändern der angewandten Kraft, **gekennzeichnet durch**
   • zwei Kollimatoren ($4i$, $4_2$) mit jeweils einen Schlitz ($6_i$, $6_2$), dessen Öffnungsbreite vom Mittelpunkt zum Umfang zunimmt, die jeweils zwischen dem ersten und zweiten und zwischen dem dritten und vierten Ablenksystem angeordnet sind, wobei die Öffnung des Schlitzes ($6i$) des ersten Kollimators ($4_i$) zu einer Seite der Emissionsachse des Strahls A0 gerichtet ist, und die Öffnung des Schlitzes ($6_2$) des zweiten Kollimators ($4i$) zur gegenüberliegenden Seite der Strahlachse (A0).

2. Vorrichtung nach Anspruch 1, **dadurch gekennzeichnet, dass** jedes der Ablenksysteme ($2i$, $2_2$, $2_3$, $2_4$) elektrisch oder magnetisch ist.

3. Vorrichtung nach Anspruch 2, **dadurch gekennzeichnet, dass** im Falle elektrischer Ablenksysteme ($2i$, $2_2$, $2_3$, $2_4$) jedes System ($2i$, $2_2$, $2_3$, $2_4$) aus zwei parallelen, auf ein elektrisches Potential gebrachten Platten (7) besteht, die jeweils zu beiden Seiten der Emissionsachse (A0) angeordnet sind.

4. Vorrichtung nach Anspruch 2, **dadurch gekennzeichnet, dass** im Falle magnetischer Ablenksysteme ($2i$, $2_2$, $2_3$, $2_4$) jedes der Ablenksysteme aus einem magnetischen Dipol besteht.

5. Vorrichtung nach einem der vorhergehenden Ansprüche, **dadurch gekennzeichnet, dass** der Schlitz ($6i$, $6_2$) eines Kollimators ($4i$, $4_2$) eine generelle V-Form hat, wobei die gegenüberliegenden Kanten gerade oder zum übrigen Teil des Kollimators ($4i$, $4_2$) oder zu dem durch diese Kanten begrenzten Hohlraum hin gekrümmt sind.

6. Vorrichtung nach einem der vorhergehenden Ansprüche, **dadurch gekennzeichnet, dass** jeder Kollimator ($4i$, $4_2$) so an der Achse positioniert ist, dass sein Schlitz ($6_i$, $6_2$) auf einer Seite der Emissionsachse A0 zu dieser Achse A0 um einen Abstand d versetzt angeordnet ist.

7. Vorrichtung nach einem der Ansprüche 1 bis 5, **dadurch gekennzeichnet, dass** jeder Kollimator ($4i$, $4_2$) so an der Achse positioniert ist, dass sein Schlitz ($6i$, $6_2$) in der Emissionsachse A0 angeordnet ist.

8. Vorrichtung nach einem der vorhergehenden Ansprüche, **dadurch gekennzeichnet, dass**, wenn sie 8 Ablenksysteme ($2i$, $2_2$, $2_3$, $2_4$) umfasst, vier dieser Systeme gegenüber der Emissionsachse angeordnet sind, um die Achse in eine erste Richtung abzulenken, und vier andere dieser Systeme ($2i$, $2_2$, $2_3$, $2_4$) gegenüber der Emissionsachse angeordnet sind, um die Achse in eine zweite Richtung senkrecht zur ersten abzulenken.

9. Verfahren zum Ablenken eines auf einer Achse A0 emittierten Strahls geladener Teilchen von seiner Emissionsachse mithilfe der Vorrichtung nach einem der vorhergehenden Ansprüche, **dadurch gekennzeichnet, dass** es bei 4N aufeinanderfolgenden Ablenksystemen einen Schritt umfasst:

- in dem durch das erste Ablenksystem (2i) eine erste Strahlablenkkraft in einer gegebenen Richtung und in einer ersten Richtung angewendet wird,
- in dem durch das zweite Ablenksystem ($2_2$) eine zweite Ablenkkraft größer als die erste in der gleichen Richtung und entgegengesetzt zur ersten angewendet wird,
- in dem durch das dritte Strahlablenksystem ($2_3$) die zweite Strahlablenkkraft in der gleichen Richtung und in der ersten Ablenkungsrichtung angewendet wird,
- in dem durch das vierte Ablenksystem ($2_4$) die erste Ablenkkraft in der gleichen Richtung und entgegengesetzt zur ersten Richtung angewendet wird.

10. Verfahren nach Anspruch 9, **dadurch gekennzeichnet, dass** die Ablenksysteme (2i, $2_2$, $2_3$, $2_4$) elektrisch sind und jeweils zwei Platten (7) parallel zur Achse AO umfassen, die zu beiden Seiten dieser Achse AO angeordnet sind, wobei die an die beiden Platten desselben Systems angelegten Potenziale symmetrisch oder asymmetrisch sind.

11. Verfahren nach Anspruch 10, bei dem jedes Ablenksystem aus zwei zu beiden Seiten der Achse (A0) angeordneten Platten besteht, wobei zwei oder mehr Platten unterschiedlicher Ablenksysteme geerdet sind, wobei die Strahlablenkkräfte der Ablenksysteme der Platten unterschiedlich sind, wobei Korrekturfaktoren (Uib) auf jede Ablenkkraft angewendet werden, die für ein Ablenksystem mit einer geerdeten Platte vorgegeben ist, um den Austrittswinkel des Strahls zu korrigieren.

12. Verfahren nach Anspruch 10, bei dem man zusätzliche einstellbare Ablenkkräfte auf ein oder mehrere Ablenksysteme anwendet, um den Austrittswinkel des Strahls zu korrigieren.

13. Anordnung zur Emission eines Strahls geladener Teilchen mit modulierbarer Intensität, die nacheinander entlang einer Emissionsachse A0 des Strahls folgendes umfasst:

- eine Quelle zur Emission eines Strahls geladener Teilchen, der um eine Emissionsachse A0 zentriert ist, vorzugsweise vom Typ ECR,
- ein Extraktionssystem,
- eine Einzellinse,
- einen Kollimator mit kreisförmiger zentraler Öffnung,
- die Vorrichtung nach einem der Ansprüche 1 bis 8,
- einen zweiten Kollimator mit kreisförmiger zentraler Öffnung
- einen Partikelfilter am Ausgang des zweiten Kollimators, über die Geschwindigkeit.

## Claims

1. A device for modulating the intensity of a charged particle beam emitted along an axis (A0), comprising:

   • $4 \times N$ consecutive deflection systems ($2_1$, $2_2$, $2_3$, $2_4$), with N = 1 or 2, with the deflection systems ($2_1$, $2_2$, $2_3$, $2_4$) being positioned along the axis (A0) of said particle beam, and being capable of deflecting the beam relative to the axis (A0) in the same direction, with alternating directions of deflection, for two consecutive systems ($2_1$, $2_2$, $2_3$, $2_4$),
   • means for applying a force for deflecting the beam for each deflection system ($2_1$, $2_2$, $2_3$, $2_4$) and for varying the applied force **characterized by**
   • two collimators ($4_1$, $4_2$) each having a slot ($6_1$, $6_2$) with an opening that increases in width from the center towards the periphery, located respectively between the first and second deflection systems and between the third and fourth deflection systems, with the opening of the slot ($6_1$) of the first collimator ($4_1$) facing towards one side of the emission axis of the beam A0, with the opening of the slot ($6_2$) of the second collimator ($4_1$) facing towards the opposite side of the emission axis of the beam (A0).

2. A device according to claim 1 **characterized in that** each of said deflection systems ($2_1$, $2_2$, $2_3$, $2_4$) is of the electrical type or of the magnetic type.

3. A device according to claim 2, **characterized in that**, when the deflection systems ($2_1$, $2_2$, $2_3$, $2_4$) are of the electrical type, each system ($2_1$, $2_2$, $2_3$, $2_4$) consists of two parallel plates (7) brought to an electric potential respectively arranged on either side of the emission axis (A0) .

4. A device according to claim 2, **characterized in that**, when the deflection systems $(2_1, 2_2, 2_3, 2_4)$ are of the magnetic type, each of said deflection systems consists of a magnetic dipole.

5. A device according to one of the preceding claims, **characterized in that** the slot $(6_1, 6_2)$ of a collimator $(4_1, 4_2)$ has a general V-shape with straight or curved opposite edges domed towards the remaining portion of the collimator $(4_1, 4_2)$ or towards the empty space defined by such edges.

6. A device according to one of the preceding claims, **characterized in that** each collimator $(4_1, 4_2)$ is placed along the axis so that the slot $(6_1, 6_2)$ thereof is positioned on one side of the emission axis A0 while being offset relative to such axis A0 by a distance d.

7. A device according to one of claims 1 to 5, **characterized in that** each collimator $(4_1, 4_2)$ is placed along the axis so that the slot $(6_1, 6_2)$ thereof is positioned in line with the emission axis A0.

8. A device according to one of the preceding claims, **characterized in that**, when it comprises 8 deflection systems $(2_1, 2_2, 2_3, 2_4)$, four of these systems are so arranged relative to the emission axis as to deflect the axis in a first direction, and four of these systems $(2_1, 2_2, 2_3, 2_4)$ are so arranged relative to the emission axis as to deflect the axis in a second direction perpendicular to the first one.

9. A method for deflecting from its emission axis a charged particle beam emitted along an axis A0, with the device according to any one of the preceding claims, **characterized in that** it comprises, for 4N consecutive deflection systems, a step of application:

   - by the first deflection system $(2_1)$, of a first force for deflecting the beam in a given direction and in a first orientation,
   - - by the second deflection system $(2_2)$, of a second force greater than the first one, for deflecting the beam in the same direction and in an orientation opposite the first one,
   - by the third beam deflection system $(2_3)$, of the second force for deflecting the beam in the same direction and in the first orientation of deflection,
   - by the fourth deflection system $(2_4)$, of the first deflecting force, in the same direction and in an orientation opposite the first one.

10. A method according to claim 9, **characterized in that** the deflection systems $(2_1, 2_2, 2_3, 2_4)$ are of the electrical type, and each comprise two plates (7) parallel to the axis A0 and arranged on either side of such axis A0, with the potentials applied to the two plates of the same system being symmetrical or asymmetrical.

11. A method according to claim 10, wherein each deflection system is composed of two plates arranged on either side of the axis (A0), with two or more plates of different deflection systems being grounded, with the forces deflecting the beams of the deflection systems of the plates being different, with correction factors (Uib) being applied to each deflecting force imposed on a deflection system, one plate of which is connected to the ground in order to correct the exit angle of the beam.

12. A method according to claim 10, wherein additional adjustable deflection forces are applied to one or more deflection system(s) in order to correct the exit angle of the beam.

13. An assembly for emitting a charged particle beam of adjustable intensity, comprising in succession along an emission axis A0 of the beam:

   - a source of emission of a charged particle beam centered about an emission axis A0, preferably of the ECR type
   - an extraction system
   - a lens of the Einzel type
   - a collimator having a circular central hole
   - the device according to any one of claims 1 to 8,
   - a second collimator having a circular central hole
   - a device speed-filtering the particles at the outlet of the second collimator.

Figure 1

Figure 2

3U1 = U2

(a)

(a)

(b)

(b)

(c)

(c)

(d)

(d)

Figure 3

Figure 4

Figure 5

Figure 6

**EP 3 427 285 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8896238 B
- US 3286123 A
- EP 2592642 A
- US 8039822 B
- US 9224569 B
- US 20090050819 A1